# EUROPEAN PATENT APPLICATION

(11) **EP 2 662 471 A1**
(43) Date of publication of application: **13.11.2013**
(21) Application number: 12167159.8
(22) Date of filing: 08.05.2012
(51) Int. Cl.: C23C 16/455, C23C 16/40

(54) **Adjustable chemical vapour deposition process**

(71) Applicant: Nederlandse Organisatie voor Toegepast -Natuurwetenschappelijk Onderzoek TNO, 2628 VK Delft (NL)
(72) Inventor: van Deelen, Joop, 2628 VK Delft (NL)
(74) Representative: Jansen, Cornelis Marinus

(57) **Abstract**

The invention relates to a chemical vapour deposition process, to a reactor for a chemical vapour deposition process, and to a process for cleaning a reactor.

The chemical vapour deposition process for preparing a layer of a solid material on a substrate, comprises: passing a gas flow comprising a precursor of the solid material over the substrate, wherein the gas flow over the substrate is controlled by adjusting, while the gas flow is passed over the substrate, a dimension of the gas flow pathway upstream, downstream and/or at the substrate.

## Description

The invention relates to a chemical vapour deposition process, to a reactor for a chemical vapour deposition process, and to a process for cleaning a reactor.

More in particular, the invention relates to a process for chemical vapour deposition of preferably a metal oxide, more preferably an oxide of zinc, germanium, cadmium, indium, tin, thallium or bismuth, most preferably zinc oxide, on a substrate, preferably glass or polymer. The metal oxide is preferably a transparent conductive oxide.

Chemical vapour deposition (CVD) is used for depositing a layer of a solid material on a substrate, typically to provide a substrate with a coating.

In a CVD process, a gas flow comprising volatile precursors of the solid material is passed over the substrate in a reactor. The properties of the deposited layer of solid material depend on the flow rate and flow pattern of the gases involved in the process. These depend on the shape and dimensions of the gas flow pathway prior to, during and/or after passing over the substrate, corresponding to positions upstream, at and downstream of the substrate, respectively. This is because the solid material will often deposit not only on the substrate, but also on surfaces of the reactor exposed to the gas flow comprising the volatile precursors. These unwanted deposits of solid material on reactor surfaces affect the shape and dimensions of the gas flow pathway, and may eventually result in clogging and plugging of the gas flow pathway. Such clogging causes a need for frequent cleaning of the reactor and therefore frequent interruption of the CVD process. Prior art CVD processes are often interrupted for 5-20 % of the time for cleaning and maintenance of the reactor. Moreover, cleaning requires opening of prior art reactors.

The cleaning frequency depends, among other factors, on the rate of unwanted deposition of solid material and the rate of clogging, the size of the inlet and outlet, the sensitivity of the deposition process to the gas flow rate and pattern and the bandwidth that is technically acceptable for the properties of the coating.

Therefore, a need exist for a chemical vapour deposition process requiring less frequent cleaning and allowing for better control of the properties of the layer of solid material. Furthermore, a need exist for a reactor allowing for such a process and allowing for more easily cleaning.

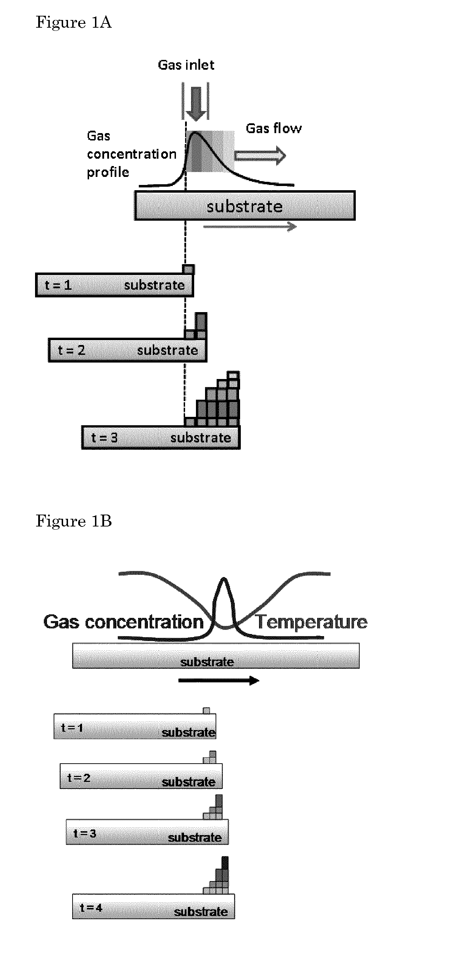

Furthermore, industrial configuration CVD processes are usually employed with a moving substrate underneath a fixed gas injector. As the position of the substrate changes during the process, each point of the substrate will be exposed to a wide variety of process conditions. As a consequence, the final layer of solid material has in fact a 'continuous stack' of sublayers, each deposited at different process conditions and therefore with different properties. A change in gas flow rate and pattern, for example due to clogging, can cause a change in precursor gas concentration profile and can therefore yield a different final layer. This is schematically shown in figures 1A and 1B. A substrate is moved in direction (*x*) through a reactor comprising a fixed gas inlet. Directly underneath (dashed line) the gas inlet the temperature profile has a minimum and the precursor gas concentration profile a maximum. The deposition of the solid material layer at various times is also visualized. The dotted line is a guide for the eye for alignment. Clearly, the final layer of solid material is composed of a number of sublayers with different composition and/or structure.

US-A-5 817 575 discloses that clogging or plugging of the outlet of an apparatus comprising a CVD chamber is prevented or substantially reduced by injecting a hot gas into the effluent line during processing. Adjusting one or more gas flow pathway dimensions is not disclosed.

EP-A-0 453 679 discloses an atmospheric pressure chemical vapour deposition apparatus with a rotating cleaning member in a toroid element forming an orifice in the exhaust line. Adjusting one or more gas flow pathway dimensions is not disclosed.

US-B-5 863 337 discloses an apparatus for chemical vapour deposition of a coating of tin oxide and silicon oxide on a moving substrate in a continuous process wherein the height between the substrate and the structural element bridging the space between inlet and outlet is changed between various runs (Example III). In this way, the tin oxide and silicon oxide fraction in the coating varies between the coatings of different runs. Also, two runs were carried out wherein the outlets were positioned different relative to the nozzle (Example II). This document does not disclose a CVD process comprising adjusting one or more gas flow pathway dimensions while the gas flow is passed over the substrate.

Objective of the invention is to provide a method for chemical vapour deposition mitigating at least one or more of the mentioned disadvantages. Specifically, an objective is to provide a CVD process allowing for better control of the properties of the layer of solid material. Further objective is to provide a continuous CVD process that needs less frequently to be interrupted for cleaning of the reactor.

Further objective is to provide a reactor suitable for use in such CVD processes. Another objective is to provide an improved cleaning process for a CVD reactor.

The inventors surprisingly found that one or more of these objectives can, at least in part, be met by a process for chemical vapour deposition of a solid material on a substrate, wherein specific parameters of the process are changed.

In a first aspect, the invention relates to a chemical vapour deposition process for preparing a layer of a solid material on a substrate, said processes comprising: passing a gas flow comprising a precursor of said solid material over said substrate, wherein the gas flow over said substrate is controlled by adjusting, at a moment said gas flow is passed of over said substrate, one or more dimensions of the gas flow pathway prior to, during and/or after passing over said substrate.

In a second aspect, the invention relates to a reactor a reactor for a chemical vapour deposition process for preparing a layer of a solid material on a substrate, preferably a process according to this invention, comprising a receiving surface for receiving a substrate to be processed, a guiding surface provided at a distance opposite the receiving surface, said surfaces defining a gas flow pathway between them, **characterised in that** one or more dimensions and/or the position of at least part of the guiding surface are adjustable.

In a further aspect, the invention relates to process for cleaning a CVD reactor, comprising moving one or more shields in a direction substantially parallel to the guiding surface.

The term "controlling the gas flow" indicates controlling, to at least some extent, one or more aspects of the gas flow, such as flow rate and/or flow pattern. Controlling the gas flow suitably comprises optimizing, adjusting and/or stabilizing these aspects.

The term "path length" is used to indicate the distance along the gas flow between an inlet and an outlet of the gas flow.

The term "height of the gas flow pathway" indicates the dimension of the gas flow pathway in the direction perpendicular to the surface of the substrate whereupon the layer of solid material is to be deposited, of the part the gas flow pathway where the gas flow is passed over the substrate.

An effective dimension, such as effective height, effective path length, effective inlet opening size and effective outlet opening size, indicates the dimension taking into account the building up of layers of deposited solid material. The building up layers of deposited solid material, such as on the substrate and on surfaces of gas flow pathway, should be ignored for the non-effective height, inlet size, outlet size, and path length.

The term "run" is used to refer to the period of continuous operation between two interruptions in a continuous process embodiment.

The term "shields" is used to refer to the structural elements of the guiding surface.

The term "recess shield" refers to a shield extending in a direction substantially perpendicular to the guiding surface and comprising a recess extending substantially parallel to the guiding surface, wherein the recess is capable of receiving at least part of another shield.

The terms "substantially" and "essentially", used for perpendicular and parallel, indicate a deviation of 30° or less, preferably 10° or less, more preferably 5° or less, more preferably 1° or less to perpendicular (*i.e*. forming an angle of 90°) and parallel (*i.e*. forming an angle of 0° or 180°) respectively, most preferably no (measurable) deviation.

Upstream and downstream are used to indicate relative positions along the gas flow.

The CVD process can be a continuous process or a batch process. The CVD process can be atmospheric pressure, low pressure or ultrahigh vacuum CVD. The CVD process can be direct liquid injection CVD or aerosol assisted CVD and can optionally be plasma assisted. The CVD process can be atomic layer deposition CVD or any kind of pulsed gas flow CVD process.

The solid material can comprise silicon, carbon (nano)fiber, carbon nanotubes, SiO₂, silicon-germanium, tungsten, silicon carbide, silicon nitride, silicon oxynitride, titanium nitride, metal oxides.

The solid material preferably comprises one or more selected from the group consisting of oxides of zinc, germanium, cadmium, indium, tin, thallium and bismuth; more preferably zinc oxide. The solid material is preferably a transparent conductive oxide.

Depending on the material and application, the thickness of the layer of solid material can vary, such as from 0.1-3000 nm, or from 50-1000 nm.

The layer of solid material can be monocrystalline, polycrystalline, amorphous, and/or epitaxial. The layer of solid material may have the same thickness and structure over the substrate or may vary at various positions of the substrate. Preferably, the layer of solid material is homogeneous along the substrate. The layer of solid material may be homogeneous or inhomogeneous along the thickness of the layer.

The substrate can comprise any suitable solid material and preferably glass, polymer, Si, SiO₂, metal, quartz, paper, textiles. A substrate for CVD is often called a wafer in the art.

The precursor is preferably volatile. Suitable precursors, as commonly used for CVD, include diethyl zinc, trimethyl aluminium, and monobutyl tin chloride.

The gas stream preferably comprises one or more of nitrogen, hydrogen, helium, argon, oxygen, and air.

The amount of precursor is preferably in the range of 0.01-20 % of the total gas flow.

The flow rate is depends on the reactor dimensions and can be between 0.1 and 1000 slm (standard litres per minute, *i.e.* litres per minute measured at standard temperature and pressure).

The gas flow pathway comprises the space through which the gas flow passes from addition of the precursor to after the substrate. In a reactor, the gas flow pathway is typically delimited by the surfaces of the reactor exposed to the gas flow.

Adjusting a dimension can be carried out by changing the dimension, such as increasing and decreasing the dimension, and includes setting a dimension. Adjusting one or more dimensions of the gas flow pathway can be carried out by changing one or more dimensions of the gas flow pathway, for example decreasing or increasing. Adjusting may occur once or multiple times during the process and may be step-wise or gradual. The dimensions may even be continuously adjusted. Two or more dimensions may be adjusted simultaneously. The dimensions may be changed independently from each other or changes in two or more dimensions may be dependent on each other. Advantageously, the invention allows a stepless (continuously variable) adjustment of the one or more dimensions. This is in contrast to embodiments wherein the user can choose between different fixed shield positions.

The gas flow over said substrate is controlled by adjusting one or more dimensions of the gas flow pathway prior to, during and/or after passing over said substrate. Controlling the gas flow is carried out as part of the CVD process.

The one or more adjusted gas flow pathway dimensions are one or more gas flow pathway dimensions upstream, downstream and/or at substrate, relative to the gas flow and gas flow direction. These positions upstream, downstream and at the substrate correspond to steps in the CVD process prior, after and during passing of the gas flow over the substrate, respectively.

For example, an inlet opening for the gas flow can be located upstream the substrate. The size of an inlet opening is a dimension of the gas flow pathway that can be adjusted upstream the substrate. An outlet opening for the gas flow can be located downstream the substrate. The size of an outlet opening is a dimension of the gas flow pathway that can be adjusted downstream the substrate.

Suitable dimension of the gas flow pathway to be adjusted include inlet opening size, outlet opening size, path length and height of the gas flow pathway. The inlet and the outlet opening are typically characterized by an angle and/or a change in the direction of the gas flow. Between an inlet opening and an outlet opening, the gas flow is typically parallel to the surface of the substrate whereupon the layer of solid material is to be deposited. Preferably, the one or more dimensions of the gas flow pathway are selected from the group consisting of inlet opening size, outlet opening size, path length and height of the gas flow pathway; the one or more dimension may be adjusted simultaneously.

The change in the height is preferably independent from changes in distance path length, inlet opening size and outlet opening size.

The process can be a continuous process or a batch process.

The CVD process can be a continuous process that is sometimes interrupted, e.g. for cleaning and/or maintenance. The gas flow pathway dimensions can be during a run, they can also be adjusted during an interruption or during both. In a preferred embodiment of the CVD process, the outlet opening size is increased during a run. This provides the advantage that the effect of clogging at the outlet opening is compensated and a desired effective outlet opening size is maintained during a run.

In an embodiment, gas flow pathway dimensions are adjusted during a run to compensate for changes in a dimension of the substrate, such as the thickness of the substrate. The height of the gas flow pathway may be increased with increases in thickness of the substrate and decreased with decreases in thickness of the substrate. When a dimension, in particular the thickness, of the substrate is known or suspected to vary, such dimension is preferably monitored before the substrate enters the reactor and one or more gas flow pathway dimensions are adjusted in response to observed changes in the property.

In a preferred embodiment, the process further comprises monitoring of a property of the layer of solid material on the substrate and adjusting a dimension of the gas flow pathway, based on said property, preferably simultaneously with passing the gas flow over the substrate. Preferably, the process is a continuous process. Monitoring of a property of the layer of solid material can be carried out by measuring continuously or frequently the property and comparing the measured value with a set value or range of values of the property. When the measured value differs from the set value or is outside the range of values, one or more dimensions of the gas flow pathway are suitably changed. The monitored property is preferably the resistivity of the layer of the solid material. In a preferred embodiment, the {effective} resistivity is monitored and the height of the gas flow pathway can be adjusted in response.

Preferably, the gas flow over the substrate is controlled by adjusting a dimension of the gas flow pathway at the substrate, wherein said dimension extends in a direction substantially perpendicular to a surface of the substrate whereupon said layer of said solid material is deposited. This dimension is suitably the height of the gas flow pathway. This allows for mitigating the effects of reduced effective height of the gas flow pathway, such as due to unwanted deposition of solid layers or changes in thickness of the substrate.

The CVD process can be a batch process. In a batch process according to this invention, the gas flow can be controlled and changed during the process by adjusting one or more gas flow pathway dimensions to optimize for the subsequent deposition of different sublayers.

The CVD process according to the present invention can advantageously be used to obtain zinc oxide coatings with desirable properties. The deposition of zinc oxide is extremely sensitive to gas flow pathway dimensions. A small change of the gas flow pathway height often has tremendous effects on the properties of the deposited layer. Maintaining the effective gas flow pathway height during the process according to the present invention advantageously allows for better control of the properties of the formed zinc oxide coating.

The CVD process according to the present invention can advantageously be used to obtain coatings of various metal oxides, such as zinc oxide, with better control of the properties. These coatings can be used as or in thin films for solar cells, light emitting diodes, opto-electronic devices and infrared reflective, visible light transparent coated substrates such as low-E glass (low emissivity glass).

In a further aspect, the invention relates to a reactor for a CVD process, preferably a CVD process as described. The reactor will now be described in detail.

The reactor comprises a receiving surface for receiving a substrate to be processed. The reactor further comprises a guiding surface. The guiding surface is provided at a distance opposite the receiving surface. The guiding surface is suitably substantially parallel to the receiving surface. The guiding surface guides the gas flow in the gas flow pathway. Suitably, the guiding surface guides the gas flow over a substrate. The guiding surface and receiving surface define a gas flow pathway between them. The reactor may further comprise an inlet and outlet for the gas flow, comprising an inlet opening and outlet opening respectively.

One or more dimensions and/or the position of at least part of the guiding surface are adjustable. This may be obtained using flexible materials and/or displaceable elements. Examples of such elements include displaceable elements, movable superimposed elements, sliding elements, extendable elements or elements that can be pulled out, folding elements and articulated elements.

The reactor may further comprise an inlet and an outlet for the substrate, or a combined inlet/outlet for the substrate. A combined inlet/outlet for the substrate is suitable in case of a batch reactor. The inlet for the gas flow can comprise a nozzle or injector as conventionally used in CVD reactors. The reactor may further comprise a heating element, a mixture chamber for addition of one or more precursors for the solid material to a gas flow or for preparing the gas flow, means for moving the substrate, and/or monitoring devices for temperature, gas flow, layer thickness, and composition, substrate position, etc.

Suitable dimensions of at least part of the guiding surface include dimensions of parts of the guiding surface, such as distances between various points of the guiding surface. Suitable positions of at least part of the guiding surface include distances between parts of the guiding surface and the receiving surface.

Preferably, the guiding surface comprises an opening for passage of a gas flow, wherein one or more dimensions and/or the position of said opening are adjustable. The gas flow is suitably the gas flow comprising a precursor for the solid material. Preferably, the guiding surface comprises both an inlet opening and an outlet opening for the gas flow. Suitable dimensions include the size of the opening. Adjustability of one or more dimensions and/or the position of an opening in the guiding surface can be obtained by locating the opening in or between one or more structural elements of the guiding surface that are displaceable and/or adjustable, such as sliding elements, elements that can be extended or pulled out, folding elements or articulated elements.

Preferably, the guiding surface comprises two or more shields extending substantially parallel to the receiving surface, wherein at least one shield is displaceable in a direction substantially parallel to the receiving surface or under a certain or varying angle.

The term shield does not imply thermal insulating or protective properties. Optionally, the shields may have thermal insulating and/or protective properties.

Suitable materials for the shields include steel, ceramics, and composites.

The shields may be orientated substantially in the (*x*) direction or at an angle to the receiving surface. The shield surface exposed to the gas flow can be located in a plane substantially parallel to the receiving surface. Shield can be flat, curved and/or have different heights and/or thickness at different positions.

The reactor further suitably comprises means for moving the shields, such as actuators mechanically connected to the shields. Suitable actuators for moving shields include motors, suitably combined with bolt and screw transducers, electrical motors, pneumatic actuators, hydraulic pistons, relays, comb drives, piezoelectric actuators.

In case the reactor is a reactor for a continuous CVD process, with an inlet and an outlet for the substrate, the plurality of shields are preferably arranged in the length of the reactor and each shield preferably extend over the width of the reactor.

The guiding surface comprises two or more shields. The guiding surface may comprise further structural elements that are not overlapping. The guiding surface may comprise structural elements that can be moved and/or elements that can not be moved in a direction substantially parallel to the receiving surface. The guiding surface may comprise structural elements that can be moved in a position wherein the structural element is overlapping with one or more other structural element and in a position wherein the structural element is not overlapping with another structural element.

At least one shield is displaceable in a direction substantially parallel to the receiving surface.

Preferably, a first shield at least partially overlaps with a further shield in a direction extending substantially perpendicular from the receiving surface. Specifically, preferably a first shield at least partially overlaps with a further shield, seen in a direction extending substantially perpendicular from the receiving surface. Preferably, each shield is, at least in some positions, at least in part overlapping with another shield, seen in a direction extending substantially perpendicular from the receiving surface. This direction is suitably the (*z*) direction. The extent of overlapping of the shields can change as at least one shield is displaceable in a direction substantially parallel to the receiving surface.

Preferably, the reactor comprises one or more inlet opening shields in or between which an inlet opening for a gas flow is located, further comprises one or more outlet opening shields in or between which an outlet opening for a gas flow is located, wherein said outlet opening shields are displaceable in a direction essentially parallel to said guiding surface independent from said inlet opening shields. This provides the advantage that the effects of unwanted deposition at the outlet opening for the gas flow can be mitigated by moving the shields, typically to increase a dimension of the size.

Preferably, a shield extends in a direction substantially perpendicular to the guiding surface and comprises a recess extending substantially parallel to the guiding surface and the recess is capable of receiving at least part of another shield.

Preferably, an inlet opening shield extends in a direction substantially perpendicular to the guiding surface and comprises a recess extending substantially parallel to the guiding surface and wherein said recess is capable of receiving at least part of an outlet opening shield.

This provides an advantageous combination of displaceable shields, in particular outlet opening shields, and gas guiding properties, in particular at the gas inlet. This provides the advantage that the outlet opening size and the gas flow path length can be changed.

Suitably, the recess shield extends substantially in the (*z*) direction. Preferably, the recess extends substantially in the (*x*) direction. Preferably, the dimension of the recess in the (*x*) direction is 10 % or more, preferably 50 % or more, even more preferably 75 % or more, most preferably 90 % or more of the dimension in that direction of the shield to be received. This provides space for the shield to be received to move in the (*x*) direction while the gas flow is guided in the gas flow pathway between the guiding surface, comprising these shields, and the receiving surface.

Optionally, the reactor further comprises an element for removing deposited materials from a shield, such as a protrusion, brush and/or scraper. The element is suitably mechanically connected or part of a shield, preferably a recess shield, preferably a recess.

Preferably, one or more shields can be moved in a direction substantially perpendicular to the guiding surface independent from the substrate. This provides the advantage that the dimension of the gas flow pathway in this direction can be adjusted. The dimension is suitably the height, in this way the effective height can be maintained and compensated for unwanted deposits of solid material on the reactor.

Preferably, the reactor further comprises means for moving the substrate over the receiving surface in a first direction and one or more shields, preferably outlet opening shields, are displaceable in a second direction substantially perpendicular to said first direction and substantially parallel to the receiving surface, optionally out of the reactor. Suitably, the reactor is a continuous process reactor. The direction wherein the shields can be moved is, suitably, the (*y*) direction. This embodiment provides the advantage that shields can be moved in the (*y*) direction, optionally out of the reactor, thereby allowing for easy cleaning, removal of unwanted deposits and/or maintenance of the shields. This is in particular advantageous for outlet opening shields.

The inlet openings are often connected to means, such as tubes, for providing the gas flow comprising the precursors, which is often reactive, and have in that case preferably a robust connection with such means. Therefore, the inlet opening shields are optionally not movable (*y*) direction, optionally neither in the (*x*) direction. The inlet shields are preferably movably in the (*z*) direction.

Preferably, the reactor comprises a plurality of combinations of an inlet opening, an outlet opening, and a guiding surface between said inlet opening and said outlet opening, wherein in each combination the position and/or dimension of said guiding surface, the position of said inlet opening, the position of said outlet opening, the dimension of said inlet opening and/or the dimension of said outlet opening are adjustable, such that the gas flow can be controlled in the same way in each combination.

In a CVD process, the layer of solid material is typically built in multiple steps, each step comprising injecting the precursor in the gas flow. For each step, the reactor comprises a section comprising a combination of an inlet opening (injector), an outlet opening, and a guiding surface in between. In the prior art, the dimensions of the guiding surface and the openings in each section are optimized for that specific section and the (sub)layer of solid material to be deposited in that section. Typically, the dimensions and position of the guiding surface and the openings are different in each section. The adjustable reactors according to the present invention provide the advantage that they can be adjusted for each section. In case one section becomes defect or clogged, another section of the reactor can be used by adjusting one or more of the dimensions and/or position of the guiding surface and/or openings. The sections do not have to be the same; however the sections have to be able to control the gas flow in that section in the same way.

Preferably, a recess shield is mechanically connected an actuator for moving the shield in the (*z*) direction. This provides the advantage that movement in the (*z*) direction of the recess shield causes movement in that direction of a shield received in the recess.

Reactors according to the present invention have the advantage that many gas flow pathway dimensions can be adjusted, providing increased flexibility. This is especially useful for reactors used for research and design, requiring hitherto frequent change or adjustment of the CVD reactor or a large number of different CVD reactors. CVD reactors according to the present invention are in contrast suitable for different CVD processes and allow for easily adjusting the gas flow pathway dimensions by moving one or more shields in one or more directions, even without opening the reactor.

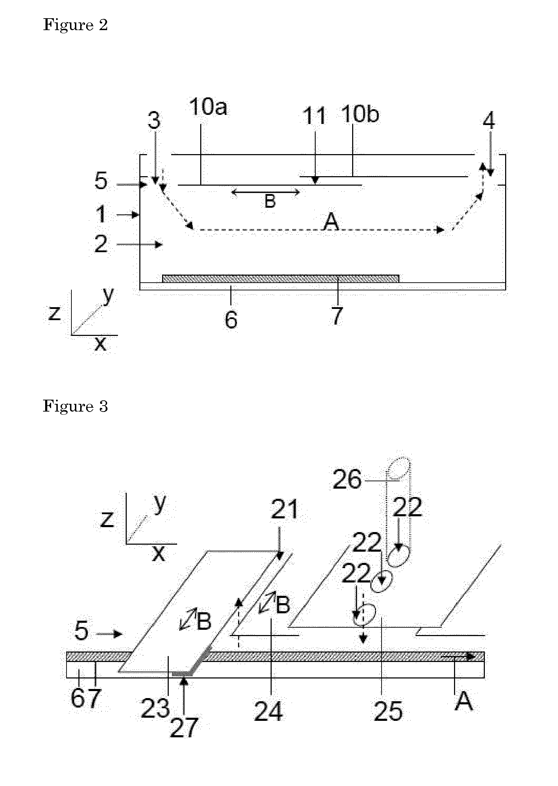

Figure 2 shows a schematic cross section of an example of a reactor according to this invention. The reactor 1 comprises a gas flow pathway 2 with a receiving surface 6, on which the substrate 7 can be received, and a guiding surface 5 provided at a distance in the (*z*) direction, opposite of receiving surface 6. The guiding surface 6 comprises two openings 3 and 4 for passage of a gas flow; opening 3 is an inlet opening and opening 4 an outlet opening. During the CVD process, the gas flow flows in a flowing direction (*x*) from inlet opening 3 through gas flow pathway 2 over substrate 7 to outlet 4 (dashed arrows A). The openings 3 and 4 are part of the gas flow pathway. The guiding surface 5 comprises two shields 10a and 10b. The (*y*) direction is a direction substantially parallel to the guiding surface and substantially perpendicular to the (*x*) direction. The shields 10 overlap at least in part, seen in the (*z*) direction at position 11. It is noted that the (*z*) direction extends substantially perpendicular away from the receiving surface in a direction of the shields. At least one of the shields is displaceable with respect to another one of the shields in the (*x*) direction. This is indicated for shield 10a with arrow B. The shields can optionally also move in the (*y*) direction. The guiding surface 5 is not necessarily parallel to the substrate surface whereupon the solid material layer is to be deposited.

In an industrial CVD process, the substrate is typically moved horizontally with respect to gravity, and therefore the (*z*) direction is substantially vertical, and the (*x*) and (*y*) directions are substantially horizontal, height is a dimension in the (*z*) direction, length a dimension in the (*x*) direction, width a dimension in the (*y*) direction, sideward is in the (*y*), backward and forward are in the (*x*) direction.

Figure 3 shows a schematic drawing of an example of a reactor according to the invention is shown in figure 3. The guiding surface 5 comprises openings 21 and 22. Either of the openings can be an inlet or outlet opening. In this case, opening 21 is an outlet opening and openings 22 are inlet openings, as indicated with the dashed arrows indicating the gas flow in the reactor. Opening 21 is located between two shields 23 and 24 and openings 22 are located in shield 25. One of the openings 22 is connected to a tube for the gas flow 26 (dotted). Substrate 7 is moved in direction (*x*), indicated by arrow A, by not shown means and surface 6. Shields 23 and 24 can move in direction (*y*), indicated by arrows B. Shield 23 is moved a bit in the (*y*) direction, allowing for easy cleaning of the shield and easy removal of unwanted deposit of solid material 27 on shield 23.

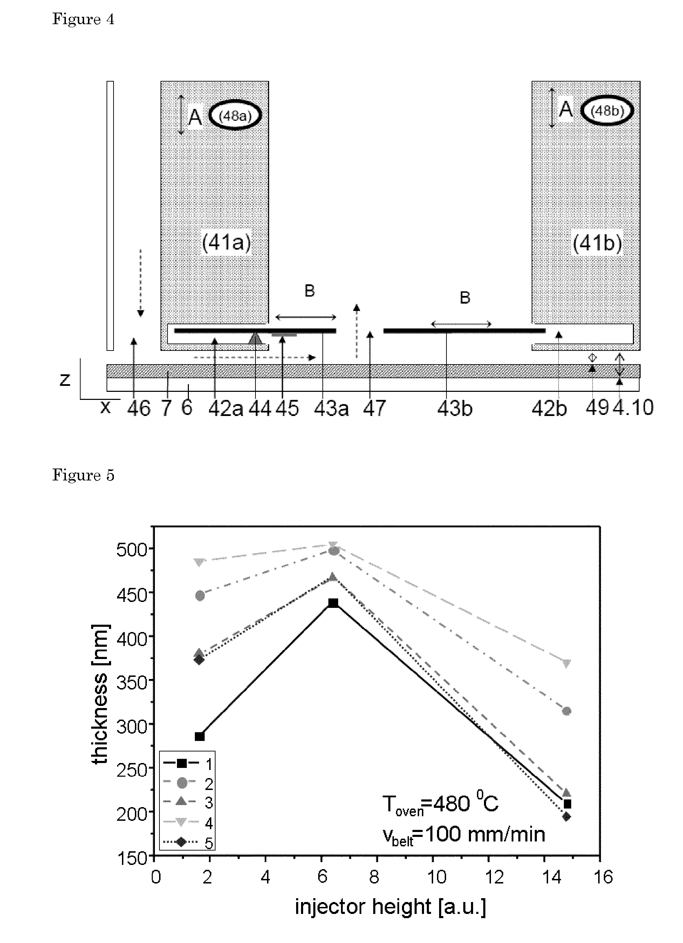

Figure 4 shows a schematic cross section of a further example of a CVD reactor according to the present invention. In this example, and also in figures 2 and 3, features from various preferred embodiments are combined. The features can also be applied separately and in other combinations.

Shield 41a and 41b extend substantially in the (*z*) direction and comprise recess 42a and 42b respectively. Recesses 42a and 42b extend substantially in the (*x*) direction. Shields 43a is received in recess 42a and shield 43b in recess 42b. Shields 43a and 43b can move in the (*x*) direction, indicated with arrows B. Shields 43a and 43b are mechanically connected to movement actuators (not shown) to move the shield in the (*x*) direction. Recess 42a comprises protrusion 44. Protrusion 44 can remove unwanted deposits of solid material, for example at position 45 at the shield 43a. Protrusion 44 can be rigid and non-flexible, but can also be a brush. The reactor further comprises inlet 46 and outlet 47. Shield 41a is an inlet opening shield and shields 43a and 43b are outlet opening shields. The gas flow is indicated with dashed arrows. The size of outlet 47 can be increased by moving shield 43a further in recess 42a and shield 43b further in recess 42b. The path length between inlet 46 and outlet 47 can be increased by moving shields 43a and 43b both in the direction of shield 41b (to the right in figure 4). The path length can be decreased by moving shields 43a and 43b both in the direction of shield 41a. Shield 41a is mechanically connected to actuator 48a and shield 41b to actuator 48b. Actuators 48a and 48b can actuate movement of the respective shield in the (*z*) direction (indicated with arrow A), optionally also in the (x) and/or (*y*) direction. This allows for change of the height of the cavity 4.10 to optimize the effective height of the gas flow pathway 49 and to mitigate the effects of eventual deposits of solid material at shield 41b on the effective height 49.

It will be clear to the person skilled in the art that the examples shown in the schematic figures merely serve the purpose of illustration and that other embodiments can be designed as well, such as a symmetrical embodiment wherein the gas originating from a gas inlet can flow in multiple directions, such as to opposite sides of the gas inlet.

The CVD reactor works as follows. Only the working of the shields is described. In other aspects, the CVD reactor works as a conventional CVD reactor.

The path length can be increased by moving one or more outlet opening shields away from the inlet opening and decreased by moving to an inlet opening. In this way, a continuous spectrum of path lengths can be obtained. The inlet size can be increased by moving two inlet opening shields, between which the inlet opening is formed, away from each other and decreased by moving such shields to each other. The outlet size can be changed in the same way. The height can be changed by moving the shields in the (*z*) direction. The shields may be moved simultaneously in the (*z*) direction and in the (*x*) direction. The path length, inlet size, outlet size and/or height may be simultaneously changed, in any combination. Path length, inlet size and outlet size are not necessarily independent from each other for all openings.

If the reactor is used in a batch process, the shields may be moved during the process. For example, the reactor in figure 2 may be used in a batch process to deposit layer of solid material 7. Layer 7 is composed of two sublayers, indicated with different shading, obtained by subsequent deposition at various conditions and/or gas flow composition. Shields 10a and 10b may be moved during deposition of substrate 7, to provide optimal gas flow pathway dimensions for deposition of each of the two sublayers.

If the reactor is used in a continuous process, the shields may be moved during a run. For example, the reactor in figure 3 may be used in a continuous process. During a run, solid material 27 may be deposited at outlet shield 23, causing clogging of outlet 21, resulting in a decreased effective size of outlet 21. The size of outlet 21 can be increased by moving shields 23 and 24 in opposite direction. The size of outlet 21 can also be increased by moving shield 23 away from shield 24, simultaneously providing an increase of path length between inlets 22 and outlet 21. The size of outlet 21 can also be increased by moving shield 24 away from shield 23, simultaneously providing a decrease of path length between inlets 22 and outlet 21. The shields may also be moved between two runs, when the process is interrupted. This allows for optimizing the gas flow pathway dimensions for each run, which is especially advantageously if different layers are deposited in each run. A reactor according to the present invention can be described as an "all-in-one reactor" as it is suitable for many different substrates, solid materials and precursors, each requiring different gas flow pathway dimensions.

The reactor may comprise a plurality of inlet and outlets arranged in the length of the reactor for deposition of various layers or sublayers. For example, to obtain a layer of solid material with sufficient thickness, the substrate may be passed underneath multiple inlets at various positions along the length of the reactor, wherein a sublayer is deposited at each inlet. This provides the advantage that the inlet and outlet can replace each other and that by moving the shields in the reactor the gas flow pathway dimensions at each inlet and outlet can be changed and optimized for the various sublayers.

The invention further relates to a process for cleaning a reactor according to this invention, said process comprising moving one or more shields in a direction substantially parallel to the guiding surface. This allows for easy cleaning of the reactor.

In an embodiment, the shields are moved in the (*y*) direction, optionally back and forth, optionally out of the reactor through an opening in a side wall of the reactor. For example, shield 23 in figure 3 has been moved in the (*y*) direction and may extend through an opening in a not shown side wall (*x-z* plane) of the reactor. The reactor may comprise one or more means for cleaning, such as brushes, or protrusions, that are located at a side of the reactor, such that by moving one or more shields in the (*y*) direction, the means come in the proximity of the shield and/or in contact with unwanted deposits of solid material on the shield, thereby brushing, scraping and/or removing said deposits of solid material.

In an embodiment, the shields are moved in the (*x*) direction, optionally back and forth, such that dirt and/or unwanted deposits of solid material at the shields become loose, optionally using elements located in the reactor, such as brushes or protrusions to brush, scrape and/or otherwise remove the dirt and/or unwanted deposits.

The invention will now be further elucidated by the following example.

### Example

A CVD apparatus having an adjustable injector height was fed with a gas flow having the following composition: 40-80 mmol/min of tertiary butanol; 0.6-1 mmol/min of diethyl zinc and a total nitrogen flow of 9 liter/min. A glass substrate was continuously moved through the CVD apparatus. The speed of the glass was varied from 100 to 500 mm/min, but this did not significantly influence the growth rate. As clearly visible from figure 5, a change in the injector height of the CVD apparatus (shown in arbitrary units) leads to a significant change in growth rate of the resulting zinc oxide layer.

## Claims

1. Chemical vapour deposition process for preparing a layer of a solid material on a substrate, comprising: passing a gas flow comprising a precursor of the solid material over the substrate, wherein the gas flow over the substrate is controlled by adjusting, while the gas flow is passed over the substrate, a dimension of the gas flow pathway upstream, downstream and/or at the substrate.

2. Process according to claim 1, wherein the solid material comprises one or more selected from the group consisting of oxides of zinc, germanium, cadmium, indium, tin, thallium and bismuth; more preferably the solid material comprises zinc oxide.

3. Process according to claim 1 or 2, wherein the process further comprises monitoring of a property of the layer of solid material on the substrate and adjusting a dimension of the gas flow pathway, based on said property.

4. Process according to anyone of claims 1-3, wherein the gas flow over the substrate is controlled by adjusting a dimension of the gas flow pathway at the substrate, wherein said dimension extends in a direction substantially perpendicular to a surface of the substrate whereupon said layer of said solid material is deposited.

5. Reactor for a chemical vapour deposition process for preparing a layer of a solid material on a substrate, preferably according to any one of claims 1-4, comprising a receiving surface for receiving a substrate to be processed, a guiding surface provided at a distance opposite the receiving surface, said surfaces defining a gas flow pathway between them, **characterised in that** one or more dimensions and/or the position of at least part of the guiding surface are adjustable.

6. Reactor according to claim 5, wherein the guiding surface comprises an opening for passage of a gas flow, wherein one or more dimensions and/or the position of said opening are adjustable.

7. Reactor according to claim 5 or 6, wherein the guiding surface comprises two or more shields extending substantially parallel to the receiving surface, wherein at least one shield is displaceable in a direction substantially parallel to the receiving surface.

8. Reactor according to claim 7, wherein a first shield at least partially overlaps with a further shield in a direction extending substantially perpendicular from the receiving surface.

9. Reactor according to claim 8, comprising one or more inlet opening shields in or between which an inlet opening for a gas flow is located, further comprising one or more outlet opening shields in or between which an outlet opening for a gas flow is located, wherein said outlet opening shields are displaceable in a direction essentially parallel to said guiding surface independent from said inlet opening shields.

10. Reactor according to any one of claims 7-9, wherein a shield extends in a direction substantially perpendicular to said guiding surface and comprises a recess extending substantially parallel to said guiding surface and wherein said recess is capable of receiving at least part of another shield.

11. Reactor according to claim 8, wherein an inlet opening shield extends in a direction substantially perpendicular to the guiding surface and comprises a recess extending substantially parallel to the guiding surface and wherein said recess is capable of receiving at least part of an outlet opening shield.

12. Reactor according to any one of claim 5-11, wherein one or more shields can be moved in a direction substantially perpendicular to the guiding surface independent from the substrate.

13. Reactor according to any one of claims 5-12, wherein the reactor further comprises means for moving the substrate over the receiving surface in a first direction and wherein one or more shields are displaceable in a second direction substantially perpendicular to said first direction and substantially parallel to said receiving surface.

14. Reactor according to any one of claims 5-13, wherein the reactor comprises a plurality of combinations of an inlet opening, an outlet opening, and a guiding surface between said inlet opening and said outlet opening, wherein in each combination the position and/or dimension of said guiding surface, the position of said inlet opening, the position of said outlet opening, the dimension of said inlet opening and/or the dimension of said outlet opening are adjustable, such that the gas flow can be controlled in the same way in each combination.

15. Process for cleaning a reactor according to any one of claim 7-12, comprising moving one or more shields in a direction substantially parallel to the guiding surface.
